Europäisches Patentamt

European Patent Office

Office européen des brevets

(19)

(11) Publication number: **0 112 380 B1**

# EUROPEAN PATENT SPECIFICATION
## published in accordance with Art. 158(3) EPC

(45) Date of publication of patent specification: **27.02.91**

(51) Int. Cl.⁵: **G01R 23/06, H03K 9/06, H03K 5/00**

(21) Application number: **83902342.1**

(22) Date of filing: **06.06.83**

(86) International application number:
**PCT/US83/00892**

(87) International publication number:
**WO 84/00087 (05.01.84 84/01)**

(54) FREQUENCY TO CURRENT CONVERTER CIRCUIT.

(30) Priority: **16.06.82 US 388952**

(43) Date of publication of application:
**04.07.84 Bulletin 84/27**

(45) Publication of the grant of the patent:
**27.02.91 Bulletin 91/09**

(84) Designated Contracting States:
**DE FR GB SE**

(56) References cited:
| | |
|---|---|
| US-A- 2 824 285 | US-A- 3 047 820 |
| US-A- 3 591 858 | US-A- 3 714 470 |
| US-A- 3 800 203 | US-A- 3 991 323 |
| US-A- 4 125 789 | US-A- 4 274 016 |
| US-A- 4 278 943 | US-A- 4 366 468 |

EDN, ELECTRICAL DESIGN NEWS, vol. 24, no. 4, February 20, 1979, pages 157-158; C. NELSON: "Improve current-source performance"

(73) Proprietor: **ROSEMOUNT INC.**
**12001 West 78th Street**
**Eden Prairie, MN 55344(US)**

(72) Inventor: **WEHRS, David L.**
**6873 Ashwood Road, No. 105**
**Woodbury, MN 55125(US)**

(74) Representative: **Cross, Rupert Edward Blount et al**
**BOULT, WADE & TENNANT 27 Furnival Street London EC4A 1PQ(GB)**

## Description

The present invention relates to a converter circuit.

In the prior art there are converter circuits that are used in connection with the conversion of a "frequency" signal, for example, a signal from a flowmeter or from a sensor that might sense a parameter, and that provides a cyclical signal that has a frequency proportional to the value of the parameter. In many instances, switching circuits are utilized wherein each time the frequency signal crosses a threshold in a preselected direction (positive going or negative going), goes positive or exceeds a value, a high voltage signal derived from an independent source is connected to an averaging circuit, and after a set time a low voltage (generally circuit common) is switched to the averaging circuit and the average voltage value is used to control current flow.

Such a circuit is disclosed in US-A-3591858 which discloses a frequency to voltage converter circuit providing an output signal having a magnitude representative of the frequency of a variable frequency input signal, comprising supply means providing first and second regulated electrical quantities of different magnitude; switching means responsive to the input signal and coupled to the supply means for alternately providing the first and second regulated electrical quantities at the output of the switching means for lengths of time dependent upon the frequency of the input signal; and averaging means coupled to the output of the switching means and operative to provide an average signal from the first and second regulated electrical quantities from the switching means.

One major problem inherent in this type of conversion is getting a non-zero output current (for example 4 milliamps) for a zero value input signal (ie. zero frequency). Usually some type of special zeroing circuit is needed in the output circuit to null against the positive output feedback signal that is present when the 4 milliamps current is flowing in the output current path.

According to this invention there is provided a converter circuit providing an output signal having a magnitude representative of the frequency of a variable frequency input signal, comprising supply means providing first and second regulated electrical quantities of different magnitude; switching means responsive to the input signal and coupled to the supply means for alternately providing the first and second regulated electrical quantities at the output of the switching means for lengths of time dependent upon the frequency of the input signal; and averaging means coupled to the output of the switching means and operative to provide an average signal from the first and second regulated electrical quantities from the switching means, characterised by output means coupled to the averaging means to receive the average signal therefrom, the regulated electrical quantities both having non-zero magnitudes, and the output means providing said output signal as a current output signal having a non-zero magnitude for an input signal having a frequency of zero Hertz.

The present invention provides a frequency to current converter circuit that provides a precise control signal derived from regulated sources to control an analog output signal in proportion to the frequency of a cyclic input signal.

The regulated electrical quantities are preferably non-zero voltage levels.

The control signal is used as a current control for regulating the current in an output current path. The currents, for example range from 4 milliamps at zero frequency of the input signal up to 20 milliamps with a 10 kilohertz input signal. The output signal can be used for process control, or can be measured directly to determine the frequency of the input signal. When the input signal frequency is dependent upon a parameter, the output signal is a function of such parameter.

The switching between two regulated sources of electrical quantity with both regulated electrical quantities having a non-zero magnitude (somewhat as described in US-A-3800203) provides an output signal that is a precise function of the frequency of the input signal, even when the frequency of the input signal is zero Hertz. The low level regulated electrical quantity determines the output signal at zero input signal frequency, and a non-zero magnitude output current can be controlled precisely because there can be a non-zero signal against which a feedback signal from the non-zero output current can be compared.

This invention will now be described by way of example with reference to the drawings, in which:

Figure 1 is a schematic-block diagram of a frequency to current converter circuit according to the invention.

Figure 2 is an expanded schematic diagram of the circuit for Figure 1 showing additional components, and

Figure 3 is a block diagram illustrating use of the circuit of the invention as part of a two-wire control system.

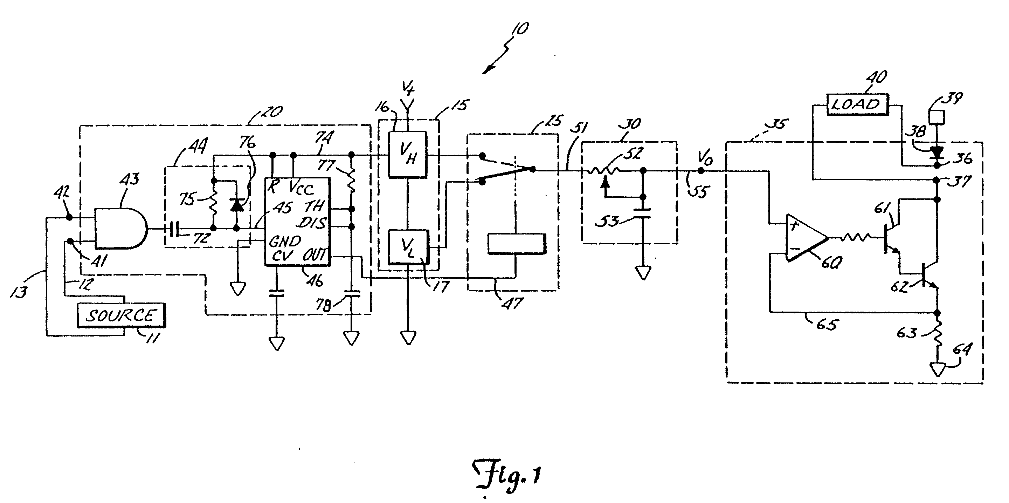

In Figure 1, the circuit 10 is adapted to convert a cyclic signal, called an input frequency signal, from a source 11 to an analog output current. Source 11 may be a sensor that provides a cyclic signal having a variable frequency proportional to the value of a parameter, along lines 12 and 13. For example, many flowmeters and magnetic flowmeters may be configured with a sensor and signal conditioning electronics to provide such a signal, such as shown in US-A-4309909 and US-A-4311053. The input may otherwise be from some other source. The output current can be used for driving a load, or used in process control for operating controls for process equipment.

The major components of the circuit 10 shown in Figure 1 comprise voltage source means 15 which comprises a source 16 of a first regulated high voltage, and a source 17 of a second regulated low voltage. The cyclic input signal from lines 12 and 13 is passed through a frequency responsive switch control circuit 20 which provides a pulse control signal to a switch 25 and causes the switch 25 to connect the high voltage source 16 to a smoothing or averaging circuit 30 such as an R-C circuit, for a selected time during each cycle of the signal from the source 11. The control pulses from control circuit 20 to switch 25 thus are at the same frequency as the input signal. The known time period during which the regulated high voltage source 16 is connected by switch 25 to averaging circuit 30 is commenced at a selected known threshold value of each cycle of the signal from source 11.

For the remainder of the time during each cycle of the cyclic signal from source 11, the switch 25 connects the regulated low voltage source 17 to the smoothing or averaging circuit 30. The output from the averaging circuit 30, which is a function of the time average of the regulated voltage provided through switch 25, comprises a control signal $V_0$, that is provided to an output stage circuit 35. The control signal $V_0$ in turn controls the level of current in a current path from a single ended voltage source 39 through a load 40 connected in series with output terminals 36 and 37. Because the voltage of the control signal from averaging circuit 30 is a function of the frequency of operation of switch 25 and thus the frequency of the input signal from source 11, the current is controlled as a function of the frequency of the input signal.

In greater detail, the switch control circuit 20 has input terminals 41 and 42 connected to lines 12 and 13. A Schmitt trigger circuit 43 is coupled to terminals 41 and 42. The Schmitt trigger 43 provides a generally square leading edge to each triggering pulse of the cyclic input signal along lines 12 and 13. It is therefore apparent that the cyclic input signal has to have signal levels that are of a magnitude which can be detected by the Schmitt trigger 43.

The output of Schmitt trigger 43, at the start of each cycle of the input frequency signal, acts through a signal level translation circuit 44 along line 45 to trigger a No. 555 TTL timer circuit 46 operating as a precision monostable multivibrator or "one shot". The "one shot" 46 is connected as a timer that provides a fifty microsecond long pulse along its output line 47 to switch 25.

Switch 25 as shown is a number 14007 CMOS Dual Complimentary Pair-Plus Inverter, wired to be driven as an analog single pole, double throw switch. The switch 25 is shown only schematically, and as stated each time the one shot 46 is triggered (once each cycle of the input signal) the fifty microsecond long pulse on line 47 causes the switch 25 to connect the regulated high voltage from source 16 to an output line 51 of the switch 25 for that fifty microsecond time period.

The output line 51 of the switch 25 is connected to the smoothing or averaging circuit 30 which includes an adjustable resistor 52 (to permit adjusting the time constant) and a capacitor 53 selected to have a desired time constant suitable for operation at the selected frequencies of the input signal. A minimum time constant of one second (95% step response) is required. While the one shot 46 provides an output signal that is precisely the same frequency as the cyclic input signal from source 11 along lines 12 and 13, the pulse width along line 47 is, as disclosed, only fifty microseconds long. During the rest of the time period of each cycle of the input signal from source 11 the regulated, low voltage source 17 having a value which is not zero or circuit common, is connected by switch 25 to the smoothing or averaging circuit 30. The control signal $V_0$ is provided along a line 55 which is at a voltage level that is a function of the average of the voltages received by the averaging circuit 30 during its time constant.

In the present application, the frequency to current converter circuit 10 is designed specifically to operate with input signal frequencies of from zero to 10 kilohertz. The fifty microsecond pulse along line 47 causes switch 25 to connect the regulated high voltage source 16 to the smoothing or averaging circuit 30 fifty percent of the time when the input signal has a frequency of 10 kilohertz.

The control signal $V_0$ on line 55 is provided to the output stage circuit 35 as stated, and in particular to the noninverting input of an operational amplifier 60 forming part of the output stage. The output current path from source 39 through load 40 includes a signal diode 38, and also includes a Darlington pair of current control transistors 61 and 62. Transistor 62 regulates or controls current through load 40 and has its collector connected to terminal 37 and its emitter connected through a feedback resistor 63 to circuit common 64.

Amplifier 60 has its output connected to the base of transistor 61 which forms the first stage of the current control. The emitter of transistor 61 is coupled to the base of the final current regulating or control transistor 62. Source 39 can be any desired source of DC voltage for providing the necessary voltage for obtaining the current desired. As shown, a 36 volt source has been found satisfactory.

The feedback signal from resistor 63 is provided by a feedback line 65 to the inverting input of amplifier 60. Amplifier 60 is effectively a current control amplifier responsive to the control signal along line 55. By selecting the value of feedback resistor 63 properly, the range of control of the transistor 62 and thus the output current will be proper for operation across the frequencies to be sensed. As stated, in many process control operations a current range between 4 and 20 milliamps is provided. For a range of 4 to 20 milliamps output current through the current path, it has been found that the regulated voltage from the high voltage source 16 in the range of 9 volts, with the regulated voltage on the low voltage source 17 approximately one volt, at 10 kilohertz the control signal on line 55 will be five volts, and at zero kilohertz the control signal will be one volt. With a feedback resistor of 250 ohms, these voltage levels provide an output current of 4 to 20 milliamps across the desired range of frequencies to be sensed.

In prior devices, zeroing the circuit for converting frequency to current was quite difficult, because the low voltage being switched was a circuit common or zero level and the low end of the output current range is positive, so that a positive feedback voltage is developed at zero frequency input signal. Thus, some type of a separate zeroing circuit is usually needed in the output stage in the prior art devices. The present circuit rids the designer of that problem. When the zero input signal is at zero frequency, there can be a nonzero control voltage provided from source 16 for offsetting the positive feedback voltage at the minimum output current value.

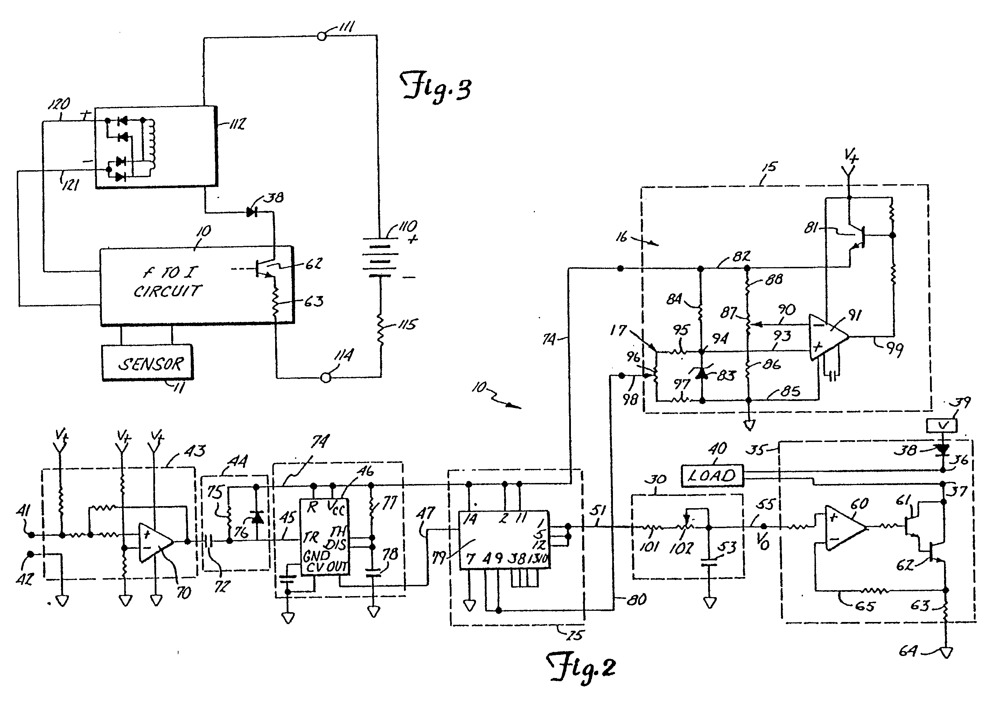

Certain circuit components are shown in greater detail in Figure 2, and it can be seen that the Schmitt trigger 43 includes an operational amplifier 70. The input terminal 42 is connected to circuit common as shown, and input terminal 41 is connected through resistors to the noninverting input terminal of the operational amplifier 70. The inverting terminal of amplifier 70 is connected to a voltage divider from a source "V +" which is, in the form shown 12 volts. The level at the inverting terminal is thus approximately six volts in the form shown. The output from the operational amplifier 70 and the Schmitt trigger 43 is fed to the line 45 through a capacitor 72. The presence of a negative going signal at terminal 41 causes the output of operational amplifier 70 to decrease, in turn causing the voltage along the line 45 to be reduced below the threshold or triggering level of one shot 46 and causing the output signal on line 47 to be a positive pulse for the fifty microsecond duration.

Energization of the one shot or precision monostable multivibrator 46 is provided by line 74 leading from the regulated high voltage source 16, which is regulated at approximately nine volts as disclosed. The use of a resistor 75 and diode 76 connected in parallel between the line 74 carrying the high regulated voltage and line 45 insures that the one shot 46 is triggered properly as the Schmitt trigger 43 output goes low. The 555 one shot 46 is powered from the line 74 carrying the high regulated voltage because the output pulse width (the fifty microsecond pulse) is sensitive to variations in supply voltage. The high regulated voltage source 16 provides a stable supply.

The time period of the one shot 46 is determined by an RC network comprising a resistor 77 and capacitor 78 connected in series across line 74 and circuit common. The resistor 77 and capacitor 78 are connected to the proper pins of the 555 forming the one shot 46. The pulse width (or time) is defined by:

$$pw = (1.1)(R_{77})(C_{78}) .$$

The switch 25 includes the 14007 CMOS Dual Complimentary Pair-Pulse Converter 79 whose terminals are connected so it operates as a single pole, double throw switch operable to connect the line 74 carrying the high regulated voltage from source 16 to output line 51 for the fifty microsecond pulse duration during each cycle of the input signal, and to connect a line 80 carrying the regulated low voltage from source 17 (which is connected to the CMOS pulse converter 79) to line 51 for the balance of the cycle time period of each cycle of the input signal. The switch 25 is also powered from the regulated high voltage source 16.

The regulated voltage sources 16 and 17 are part of the voltage source means 15. As shown in Figure 2, a voltage source (V +) which is an unregulated supply at approximately 12 volts, is connected through a transistor 81 to a line 82 connected in turn to line 74. A voltage reference means such as a Zener diode 83 is connected in series with a resistor 84 between line 82 and a circuit common line 85. A voltage divider comprising a resistor 86, a potentiometer 87 and a resistor 88 are also connected between line 82 and the circuit common line 85. The wiper of the potentiometer 87 is connected to a line 90 that is connected to the inverting input of an operational amplifier 91, and the noninverting input of amplifier 91 is connected through a line 93 to a junction 94 which is at a reference voltage level established by Zener diode 83. Junction 94 is coupled through a resistor 95 to a potentiometer 96 which is connected in series to a resistor 97, which is also connected to the circuit common line 85. The wiper 98 of the potentiometer 96 is coupled to the low regulated voltage line 80.

The output of operational amplifier 91 is connected through a line 99 and a resistor to the base of transistor 81 which is also coupled through a resistor to the voltage source V+. Thus it can be seen that the voltage at junction 94 is maintained at the set voltage controlled by the Zener diode 83, and the low regulated voltage on wiper 98 and line 80 is adjusted merely by moving the potentiometer until the voltage level on line 80 is at the desired value. The resistors 95, 97 and potentiometer 96 are selected to provide the proper voltage range. Thus the low regulated voltage is regulated independently and adjusted independently of the high regulated voltage.

The Zener diode 83 provides a very stable regulated voltage at junction 94 which is temperature stable depending on the characteristics of the diode.

In order to regulate the voltage on line 82, and thus the high regulated voltage provided on line 74, the potentiometer 87 can be adjusted to change the value of the voltage at the inverting input terminal of operational amplifier 91. Because the noninverting input terminal of amplifier 91 is maintained at the reference voltage set by the Zener diode 83, the change in voltage on line 90 will cause a change in voltage on line 99, thereby resulting in a change in current being passed by transistor 81. If the current increases it will be dumped through resistor 84 and the Zener diode 83, and this will cause the voltage on line 82 to be raised due to a change in the voltage drop across the resistor 84. Balance will be restored at the inputs of amplifier 91 and the voltage on line 82 will thus be regulated at a new level determined by potentiometer 87. In particular, the amplifier 91 shields the regulated high and low voltages from each other such that the first and second adjusting means, comprising potentiometer 96 and potentiometer 87, adjust the magnitudes of the regulated low and high voltages, respectively without affecting the magnitudes of each other. The change in current flow that changes the high voltage does not affect substantially the Zener diode voltage for normal current flows through transistor 81, thus the low and high regulated voltages are independently adjustable.

The regulation of the high regulated voltage independent of the value of the low regulated voltage, despite changes in supply voltage V+ is generally as follows. If V+ increases, it causes an initial increase in voltage at line 82, which in turn raises the voltage at line 90 with respect to the reference voltage at line 93. This causes the output on line 99 of amplifier 91 to drop, thus reducing current flow through transistor 81 and reducing voltage at line 82 to its regulated value. Balance is restored at the inputs to amplifier 91, and the high voltage at line 82 is regulated. Similar regulation occurs when V+ decreases.

The adjustable resistor shown generally at 52 in Figure 1 of smoothing or averaging circuit 30 may specifically include a fixed resistor 101 in series with a potentiometer 102 as shown in Figure 2. The potentiometer permits adjusting the time constant of the smoothing or averaging circuit with capacitor 53 at one microfarad and resistor 101 at 300 K ohm, a 5 meg ohm single turn potentiometer as potentiometer 102 provided time constant adjustments of from 1 to 15 seconds. The components are chosen to also minimize ripples in $V_O$. Longer time constants can be attained by using larger resistors or in other conventional ways. Also, amplifier 60 is chosen to have high input resistance and low input current requirements.

Because some nonlinearity error may be introduced by discharge currents of averaging circuit 30 and to a lesser degree by charge currents, the current through the networks of voltage source means 15 is kept quite high, for example 5 milliamps. The circuits for regulated sources 16 and 17 are quite temperature stable and simple to build.

In Figure 3 a typical arrangement for use of the circuity 10 in combination with a two wire process control system is shown only in block diagrams for simplicity. In this instance, the circuit 10 which converts freqency to current is connected into a two wire process control circuitry wherein two wires carry a signal such as a DC curent $I_r$ which has a magnitude representative of the parameter to be measured as well as power for the sensing apparatus.

In this case the circuit 10 represented by a block is sensitive to a sensor or flowmeter as source 11, which provides a cyclic signal that has a frequency which is dependent on a variable parameter and which will be sensed and made proportional to an analog output current. The two wire system includes a power source 110 having a line connected in series through a current input terminal 111 to an isolated power supply 112. The power supply 112 is preferably a DC to DC converter and can be of any desired form which will provide a voltage drop to thereby establish a voltage corresponding substantially to the voltage of source 39, and will have an isolated output that will provide voltages at a selected level for powering components of the circuit 10. For example, the isolated power supply 112 establishes a voltage for the signal diode 38 which is connected to the collector of transistor 62 in circuit 10. The output terminals 36 and 37 are coupled together and not utilized. The emitter of transistor 62 is connected through the feedback resistor 63, but the other end of the feedback resistor is connected through a line to a terminal 114 comprising a current return terminal that is connected to a load resistor 115 which in turn is connected in series with the power supply 110. Load resistor 115 may comprise an actuator, a controller, a recorder or simply a current indicating instrument.

It can be seen that the feedback resistor 63 is connected to the terminal 114 to complete a two wire circuit having terminals 111 and 114 through which a power source and load in series can be coupled for powering the circuit and for receiving the 4-20 milliamp (or other current) signal. The feedback signal from resistor 63 controls the current flow as previously described.

The isolated power supply 112 is made to have an isolated voltage output along a line 120 which is the proper voltage level (for example 12 volts) for use as the V+ source in the form shown in Figures 1 and 2. A line 121 which comprises the return of the isolated output of the isolated power supply 112 is connected to the circuit common connections shown in Figures 1 and 2 of the present application.

The schematic showing of Figure 3 shows that an isolated power supply 112 and circuit 10 can be operated through the two wires connected to terminals 111 and 114 to establish the 36 volt supply 39 as well as the V+ supply for the components. The power supply 112 also can be used for powering the sensor comprising sensor 11. The operation of the circuit 10 will be exactly the same as described, except that the output current will pass through the feedback resistor 63, and through the return terminal 114 to the load 115 and then returned to the power supply 110.

The connections of power supply 112 and circuit 10 can also be made so that they are similar to that shown in US-A-3764880 which shows a DC to DC converter.

## Claims

1. A converter circuit (10) providing an output signal having a magnitude representative of the frequency of a variable frequency input signal, comprising supply means (15) providing first and second regulated electrical quantities of different magnitude; switching means (20, 25) responsive to the input signal and coupled to the supply means (15) for alternately providing the first and second regulated electrical quantities at the output (51) of the switching means (25) for lengths of time dependent upon the frequency of the input signal; and averaging means (30) coupled to the output (51) of the switching means (25) and operative to provide an average signal from the first and second regulated electrical quantities from the switching means (25), characterised by output means (35) coupled to the averaging means (30) to receive the average signal therefrom, the regulated electrical quantities both having non-zero magnitudes, and the output means (35) providing said output signal as a current output signal having a non-zero magnitude for an input signal having a frequency of zero Hertz.

2. A circuit as claimed in Claim 1, characterised in that the supply means (15) includes first and second adjusting means (87, 96) for adjusting the magnitudes of the first and second regulated electrical quantities.

3. A circuit as claimed in Claim 2, characterised in that the first and second adjusting means (87, 96) provide substantially non-interacting adjustment.

4. A cirouit as claimed in any preceding Claim characterised in that the first and second regulated electrical quantities are voltage levels.

## Revendications

1. Circuit de conversion (10) délivrant un signal de sortie présentant une dimension représentative de la fréquence d'un signal d'entrée à fréquence variable, comportant des moyens d'alimentation (15) délivrant des première et seconde grandeurs électriques réglées de dimension différente, des moyens de commutation (20, 25) sensibles au signal d'entrée et reliés aux moyens d'alimentation (15) pour délivrer de façon alternée à la sortie (51) des moyens de commutation (25), pour des durées de temps qui dépendent de la fréquence du signal d'entrée, les première et seconde grandeurs électriques réglées, et des moyens de calcul de moyennes (30) reliés à la sortie (51) des moyens de commutation (25) et agissant pour fournir un signal de moyenne à partir des première et seconde grandeurs électriques réglées en provenance des moyens de commutation (25), caractérisé par des moyens de sortie (35) reliés aux moyens de calcul de moyennes (30) afin d'en recevoir le signal de moyenne, les grandeurs électriques réglées présentant toutes deux des dimensions différentes de zéro et les moyens de sortie (35) délivrant ledit signal de sortie sous la forme d'un signal de sortie en courant présentant une dimension différente de zéro pour un signal d'entrée présentant une fréquence de zéro hertz.

2. Circuit suivant la revendication 1, caractérisé en ce que les moyens d'alimentation (15) comportent des premier et second moyens de réglage (87, 96) pour le réglage des dimensions des première et seconde grandeurs électriques réglées.

3. Circuit suivant la revendication 2, caractérisé en ce que les premier et second moyens de réglage (87, 96) procurent un réglage sensiblement dépourvu d'interaction.

4. Circuit suivant l'une quelconque des revendications précédentes, caractérisé en ce que les première et seconde grandeurs réglées sont des niveaux de tension.

**Ansprüche**

1. Umwandlungsschaltkreis (10) für die Erzeugung eines Ausgangssignals mit einer Signalgröße, die die Frequenz eines Eingangssignals mit variabler Frequenz wiedergibt, mit einer versorgungseinrichtung (15), die erste und zweite geregelte elektrische Größen unterschiedlicher Signalgröße erzeugt; mit einer Schalteinrichtung (20, 25), die auf das Eingangssignal anspricht und mit der Versorgungseinrichtung (15) verbunden ist, um abwechselnd die erste und die zweite geregelte elektrische Größe an dem Ausgang (51) der Schalteinrichtung (25) für Zeitabschnitte anzulegen, die von der Frequenz des Eingangssignals abhängen; und mit einer Mittelungseinrichtung (30), die mit dem Ausgangsanschluß (51) der Schalteinrichtung (25) verbunden ist und mit welcher ein Durchschnittssignal aus der ersten und der zweiten geregelten elektrischen Größe aus der Schalteinrichtung (25) abgebbar ist, **gekennzeichnet** durch eine Ausgangsvorrichtung (35), die mit der Mittelungseinrichtung (30) verbunden ist, um das Durchschnittssignal von dieser zu empfangen, wobei beide geregelten elektrischen Größen eine Signalgröße ungleich Null aufweisen, und dadurch, daß die Ausgangsvorrichtung (35) das Ausgangssignal als ein Strom-Ausgangssignal mit einer von Null abweichenden signalgröße für ein Eingangssignal mit einer Frequenz von 0 Hz erzeugt.

2. Schaltkreis nach Anspruch 1, dadurch gekennzeichnet, daß die Versorgungseinrichtung (15) eine erste und eine zweite Einstelleinrichtung (87, 96) für das Einstellen der Signalgrößen der ersten und zweiten geregelten elektrischen Größen aufweist.

3. Schaltkreis nach Anspruch 2, dadurch gekennzeichnet, daß die erste und die zweite Einstelleinrichtung (87, 96) eine im wesentlichen nicht miteinander in Wechselwirkung stehende Einstellung schaffen.

4. Schaltkreis nach einem der vorhergehenden Ansprüche, dadurch gekennzeichnet, daß die ersten und zweiten geregelten elektrischen Größen Spannungspegel sind.

Fig. 1

EP 0 112 380 B1

Fig. 3

Fig. 2

EP 0 112 380 B1